# EUROPÄISCHE PATENTSCHRIFT

(11) **EP 0 924 281 B1**
(45) Veröffentlichungstag und Bekanntmachung des Hinweises auf die Patenterteilung: **21.05.2003**
(21) Anmeldenummer: 98204200.4
(22) Anmeldetag: 10.12.1998
(51) Int. Cl.: C09K 11/06

(54) **Organische lichtemittierende Diode mit Terbiumkomplex**
Organic light emitting diode with a terbium complex
Dispositif organique émettant de la lumière avec un complexe de terbium

(30) Priorität: 18.12.1997 DE 19756361
(43) Veröffentlichungstag der Anmeldung: 23.06.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Boerner, Herbert Dr., Philips Patentverw.GmbH, 22335 Hamburg (DE); Busselt, Wolfgang, Philips Patentverw.GmbH, 22335 Hamburg (DE); Jüstel, Thomas Dr., Philips Patentverw.GmbH, 22335 Hamburg (DE); Nikol, Hans .Dr., Philips Patentverw.GmbH, 22335 Hamburg (DE)
(74) Vertreter: Volmer, Georg, Dipl.-Ing.

(56) Entgegenhaltungen:
- WO-A-96/05607
- US-A- 5 128 587
- KIDO J ET AL: "White-light-emitting organic electroluminescent device using lanthanide complexes" JAPANESE JOURNAL OF APPLIED PHYSICS, Bd. 3B, Nr. 35, Seite L394 L394 XP002079654
- SOKOLOWSKI, ACHIM ET AL: "Phenoxyl Radical Complexes of Zinc(II)" J. AM. CHEM. SOC. (1997), 119(38), 8889-8900 CODEN: JACSAT;ISSN: 0002-7863, XP002096745
- GERALDES, CARLOS F. G. C. ET AL: "Nuclear magnetic relaxation dispersion profiles of aqueous solutions of a series of gadolinium(NOTA) analogs" MAGN. RESON. MED. (1992), 27(2), 284-95 CODEN: MRMEEN;ISSN: 0740-3194, XP002096746
- JONES-WILSON T M ET AL: "New Hydroxybenzyl and Hydroxypyridylmethyl Substituted Triazacyclononane Ligands for Use with Gallium(III) and Indium(III)" NUCLEAR MEDICINE AND BIOLOGY, Bd. 22, Nr. 7, Oktober 1995, Seite 859-868 XP004051720
- ARMAROLI N ET AL: "Luminescence properties of Eu/sup 3+/, Tb/sup 3-/, and Gd/sup 3+/ complexes of the hexadentate N-donor podand tris- 3-(2 -pyridyl)pyrazol-1ylhydroborate" CHEMICAL PHYSICS LETTERS, Bd. 5-6, Nr. 276, Seite 435 435 XP002074915

## Beschreibung

Die Erfindung betrifft eine organische lichtemittierende Diode für Leuchtanzeigen, Leuchten, Festkörperbildverstärker, Farbmonitore, Farbbildschirme u.ä. mit einem Schichtverbund aus aufeinanderfolgend einer Substratschicht, einer ersten Elektrodenschicht, einer Schicht mit einem p-leitenden organischen Material, einer Schicht mit einer Komplexverbindung des Terbiums mit organischen Liganden, einer Schicht mit einem n-leitendem Material und einer zweiten Elektrode.

Lichtemittierende Dioden (LED) nach dem Stand der Technik sind in der Regel Halbleiterdioden, also Dioden, für deren Aufbau anorganische Halbleiter wie dotiertes Zinksulfid, Silizium, Germanium oder III-V-Halbleiter, z.B. InP, GaAs, GaAlAs, GaP oder GaN mit entsprechenden Dotierungen verwendet werden. Seit einigen Jahren wird auch an der Entwicklung von Lumineszensstrahlungsquellen gearbeitet, deren Emittermaterial kein anorganischer Halbleiter, sondern ein organisches, elektrisch leitendes Material ist.

Lichtemittierende Dioden mit leuchtenden Schichten, die aus organischen Materialien aufgebaut sind, sind Lichtquellen aus anorganischen Materialien in einigen Eigenschaften deutlich überlegen. Ein Vorteil ist ihre leichte Formbarkeit und hohe Elastizität, die etwa für Leuchtanzeigen und Bildschirme neuartige Anwendungen ermöglicht. Diese Schichten können leicht als großflächige, flache und sehr dünne Schichten hergestellt werden, für die zudem der Materialeinsatz gering ist. Sie zeichnen sich auch durch eine bemerkenswert große Helligkeit bei gleichzeitig kleiner Ansteuerspannung aus.

Weiterhin kann die Farbe des emittierten Lichtes durch Wahl der lumineszierenden Substanz in weiten Bereichen von ca. 400 nm bis ca. 650 nm variiert werden. Diese Farben fallen durch ihre Luminanz auf.

Man hat auch schon Kombinationen von elektrisch leitenden organischen Materialien mit metallo-organischen Verbindungen der Seltenerdmetalle für organische, lichtemittierende Dioden eingesetzt, um für Farbdisplays eine verbesserte Farbreinheit und exakte Farbpunkte gemäß der EBU-Norm zu erhalten. Aus der DE 44 28 450 ist ein organisches elektrolumineszentes Bauteil mit einem Schichtverbund aus einer Substratschicht, einer ersten transparenten Elektrodenschicht, einer oder mehreren optoelektronisch funktionellen Schichten mit gegebenenfalls einem oder mehreren p-leitenden, organischen Materialien mit ein oder mehreren Singulett-Zuständen und ein oder mehreren Triplett-Zuständen und einem lumineszierenden Material mit einem oder mehreren Komplexen eines Seltenerdmetallions mit organischen Liganden, wobei sowohl das Seltenerdmetallion einen emittierenden Zustand und die organischen Liganden ein oder mehrere Singulett-Zustände und ein oder mehrere Triplett-Zustände haben und einem oder mehreren n-leitenden, organischen Materialien mit ein oder mehreren Singulett-Zuständen und ein oder mehreren Triplett-Zuständen und einer zweiten Elektrode, wobei der energetisch niedrigste Triplett-Zustand der Liganden niedriger als die energetisch niedrigsten Triplett-Zustände des n-leitenden und/oder des p-leitenden, organischen Materials und über dem emittierenden Zustand des Seltenerdmetallions liegt. Das Seltenerdmetallion kann beispielsweise ein Terbium(III) - Ion sein.

In diesen organischen lichtemittierenden Dioden können die Schichten aus p-leitendem oder n-leitendem Material und die Schicht mit einer Komplexverbindung des Terbiums auf verschiedene Weise hergestellt werden. Die Komplexverbindung des Terbiums kann beispielsweise allein oder zusammen mit dem p-leitenden Material und dem n-leitenden Material in einer Matrix aus einem Polymeren, z.B. Polycarbonat, Polymethacrylat, gelöst werden. Die Komplexverbindung des Terbiums kann auch allein oder zusammen mit dem p-leitenden und dem n-leitenden Material als Schicht aufgedampft werden.

Um für diese Herstellungsverfahren geeignet zu sein, soll die Komplexverbindung des Terbiums löslich in den unpolaren Lösungsmitteln sein, die die Polymere lösen, sowie löslich in den Polymeren selbst sein. Außerdem soll sich die Komplexverbindung des Terbiums unzersetzt verdampfen oder sublimieren-lassen.

Es ist daher die Aufgabe der vorliegenden Erfindung, eine organische lichtemittierende Diode mit einer Komplexverbindung des Terbiums mit organischen Liganden zur Verfügung zu stellen, die sich leicht herstellen läßt.

Erfindungsgemäß wird die Aufgabe gelöst durch eine organische lichtemittierende Diode mit einem Schichtverbund aus aufeinanderfolgend einer Substratschicht, einer ersten Elektrodenschicht, einer Schicht mit einem p-leitenden, organischem Material, einer Schicht mit einer Komplexverbindung des Terbiums mit organischen Liganden, einer Schicht mit einem n-leitendem Material und einer zweiten Elektrode, wobei die Komplexverbindung des Terbiums mit organischen Liganden die Zusammensetzung TbL(C₂H₅OH)₂ mit L = N,N',N" -Tris- (3-R₁-,5-R₂-2-X-benzyl)-1,4,7-triazacyclononan, wobei X= -O-, COO-, R₁ = CH₃, C₂H₅, C₃H₇, i-C₃H₇, t-C₄H₉, OCH₃, OC₂H₅, OC₃H₇, O^{t}C₄H₉, F, Cl, Br, NO₂ und R₂ = CH₃, C₂H₅, C₃H₇, i-C₃H₇, t-C₄H₉, OCH₃, OC₂H₅, OC₃H₇, O^{t}C₄H₉, F, Cl, Br, NO₂ ist, hat.

Dieser neutrale Terbiumkomplex mit dem makrozyklischen Chelatliganden L mit 1,4,7-Triazanonan als Grundkörper ermöglicht eine überraschend hohe Emissionsquantenausbeute in der Diode. Die Komplexe sind außerdem mononuklear, daher leicht unzersetzt sublimierbar. Sie sind unzersetzt löslich in unpolaren Solventien z.B. Kohlenwasserstoffen wie Toluol, Cyclohexan, halogenierten Kohlenwasserstoffen wie Dichlorethan, Dichlormethan, Chloroform oder Chlorbenzol, und in Polymeren wie Polyacrylat, Polystyrol u.ä.

Im folgenden wird die Erfindung anhand einer Zeichnung und einem Beispiel weiter erläutert.

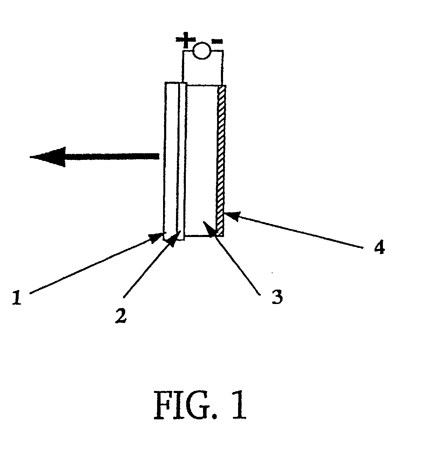

**Fig. 1** zeigt eine Ausführungsform der erfindungsgemäßen organischen lichtemittierenden Diode. In dieser Ausführungsform besteht die erfindungsgemäße organische lichtemittierende Diode aus einem Schichtverbund aus einer Substratschicht **1**, einer ersten, transparenten Elektrodenschicht **2,** einer Schicht **3** mit einem p-leitenden, organischen Material und mit einem lumineszierenden Terbiumkomplexen, einer Schicht mit n-leitenden, organischen Material **5** sowie einer zweiten Elektrode 4.

Im Betrieb wird eine Gleichstromspannung an die beiden Elektroden angelegt. Dabei liegt die erste Elektrode auf positivem Potential (Anode), die zweite auf negativem Potential (Kathode).

Als Substrat **1** dient immer eine Platte aus einem lichtdurchlässigen Material, beispielsweise eine Glasplatte. Darauf ist als dünner Film von einigen 100 nm Dicke die Anode **2** aufgebracht, die ebenfalls lichtdurchlässig sein muß. Darauf folgen die p- leitende Schicht mit dem Terbiumkomplex, dann die n-leitende Schicht. Die Dicken dieser Schichten liegen zwischen 10 und 100 nm. Vervollständigt wird das organische, elektrolumineszente Bauteil durch die Kathode **4.**

Als Material für die transparente Anode, von der aus Löcher in die p-leitende Schicht injiziert werden, sind Metalle, Metalloxide oder elektrisch leitende organische Polymere mit hoher Austrittsarbeit für Elektronen geeignet. Beispiele sind dünne, transparente Schichten aus indiumdotiertem Zinnoxid (ITO), Gold oder Polyanilin.

Für die p-leitende Schicht können molekular dotierte organische Polymere oder intrinsisch leitende organische Polymere, d.h. Polymere mit Eigenleitfähigkeit oder leitfähige organische Monomere verwendet werden. Ein Beispiel für ein intrinsisch p-leitendes, organisches Polymeres ist Poly(N-Vinylcarbazol).

Traditionell dienen organische Polymere wegen ihrer meist verschwindend geringen elektrischen Leitfähigkeit als Isolatoren oder Ummantelungen in der Elektro- und Elektronikindustrie. In jüngster Zeit ist es jedoch gelungen, die Leitfähigkeit von organischen Polymeren durch Dotierungen, also durch Einbringen genau definierter Verunreinigungen, so zu modifizieren, daß sie auch als Stromleiter in elektronischen Systemen fungieren können. Solche dotierten organischen Polymere sind z. B. mit Arsenpentafluorid oder Jod dotiertes Polyacetylen. Diese zeigen metallischen Glanz.

Eine andere Klasse von dotierten organischen Polymeren sind die sogenannten "molekular dotierten Polymere" (MDP), wie sie beispielsweise in P.M. Bausenberger und D.S. Weiss, "Organic Photoreceptors for Imaging Systems", Marcel Dekker, New York (1993) beschrieben sind. Dies sind molekulardisperse binäre feste Lösungen von Monomeren, die elektrische Ladungen transportieren können, in inerten, inaktiven polymeren Matrixmolekülen.

Ein ausgezeichnet geeigneter MDP-Werkstoff mit p-leitenden Eigenschaften ist die feste Lösung aus dem p-Leiter N,N'-Diphenyl-N,N'-bis(3-methylphenyl)-1,1'-biphenyl-4,4'-diamin (TPD) als Dotierung in einer Matrix aus Polymethylmetacrylat oder Bisphenol A - Polycarbonat.

Für die p-leitende Schicht ist auch Poly(p-Phenylenvinylen) und dessen Derivate geeignet. Bevorzugt werden leitende Triphenylaminderivate wie 4,4',4"-Tris(3-methylphenylamino)triphenylamin (MTDATA), N,N'-Diphenyl-N,N'-bis(3-methyl-phenyl)-1,1'-biphenyl-4,4'-diamin (TPD), N,N'- Di(4-Methyl-phenyl)-N,N'-diphenyl-1,4-phenylendiamin (DPPD) oder 1,1'-bis-(4'-bis-(4'-methyl-phenyl)-amino-phenyl)-cyclohexan (TAPC) verwendet.

Für die elektronentransportierende Schicht, die in Kontakt mit der Kathode und der Mischschicht steht, werden bevorzugt 2-(4-Biphenylyl)-5-(tert.-butylphenyl)-1,3,4-oxadiazol (butyl-PBD), 2-(4-Biphenylyl)-5-phenyl-1,3,4-oxadiazol (PBD) oder 5-(4-Biphenylyl)-3-(tert.-butylphenyl)-1,2,4-triazol (TAZ) verwendet.

Für die Schicht mit n-Leitung werden ebenfalls intrinsisch leitende organische Monomere und Polymere oder mit molekularer Dotierung versehene Polymere eingesetzt. Intrinsisch leitende organische Monomere, die für die elektronentransportierende Schicht geeignet sind, sind 3,4,9,10-Perylen-tetracarboxy-bis-benzimidazol, 2-(4-Biphenylyl)-5-(tert.-butylphenyl)-1,3,4-oxadiazol (butyl-PBD), 2-(4-Biphenylyl)-5-phenyl-1,3,4-oxadiazol oder 2,5-Diphenyl-1,3,4-oxadiazol (PPD) und 8-Hydroxychinolin-Aluminium (Alq₃).

Als n-leitendes molekular dotiertes organisches Polymere kann ein mit 8-Hydroxychinolin-Aluminium (Alq₃) versetztes Polymethyl-methacrylat verwendet werden.

Weitere molekular dotierte organische Polymere, die erfindungsgemäß verwendet werden können, setzen sich beispielsweise aus Polymethyl-methacryl (PMMA), Polystyrol oder Bisphenol A - Polycarbonat als Matrix mit einer Dotierung aus Oxadiazolen wie 2-(4-Biphenylyl)-5-(tert.-butyl-phenyl)-1,3,4-oxadiazol und 2,5-Diphenyl-1,3,4-oxadiazol oder Triazole wie 3,4,5-Triphenyl-2,2,4-triazol und 3-(4'-t-butylphenyl)-4-phenyl-5-(4"-biphenyl)-1,2,4-triazol zusammen.

Das elektrolumineszierende Material enthält die Komplexverbindung des Terbiums mit organischen Liganden die Zusammensetzung TbL(C₂H₅OH)₂ mit L = N,N',N"-Tris- (3-R₁-,5-R₂-2-X-benzyl)-1,4,7-triazacyclononan, wobei X= -O-, -COO-, R₁ = CH₃, C₂H₅, C₃H₇, i-C₃H₇, t-C₄H₉, OCH₃, OC₂H₅, OC₃H₇, O^{t}C₄H₉, F, Cl, Br, NO₂ und R₂ = CH₃, C₂H₅, C₃H₇, i-C₃H₇, t-C₄H₉, OCH₃, OC₂H₅, OC₃H₇, O^{t}C₄H₉, F, Cl, Br, NO₂ ist, hat.

Mit den Terbiumkomplexen wird Fluoreszenz im grünen Spektralbereich erzeugt.

Der makrozyklische, dreibindige Ligand L enthält 1,4,7-Triazacyclononan als Grundkörper, das an jedem Stickstoffatom durch ein Phenol- oder Benzoesäurederivat substituiert ist. Es hat sich überraschenderweise gezeigt, daß mit Phenolaten oder Benzoaten als Bindungsstellen zum Terbium(III)-Ion ein sehr effizienter Energieübertrag vom Liganden zum Metallion stattfindet und daß somit hohe Emissionsquantenausbeuten erzielt werden können.

Die Konzentration des Terbiumkomplexes sollte 20 Molprozente nicht übersteigen, um die Transporteigenschaften der leitenden organischen Polymeren nicht zu beeinflussen.

Als Werkstoff für die Kathode werden Metalle mit niedriger Austrittsarbeit eingesetzt, da von der Kathode her Elektronen in die n-leitende Schicht injiziert werden müssen. Solche Metalle sind Aluminium, Magnesium und Legierungen von Magnesium mit Silber oder Indium sowie Calcium, Alkalimetalle wie Li, Na, K, Cs, oder Seltenerdmetallen wie Europium oder Terbium.

Zur Herstellung der Diode können die n- oder p-leitenden Materialien aus Lösung aufgebracht, im Hochvakuum aufgedampft, sublimiert oder in situ polymerisiert werden.

Die Schicht mit dem Terbiumkomplex kann aufsublimiert werden, gegebenenfalls zusammen mit den elektrisch leitenden, organischen Monomeren.

Wenn der Terbiumkomplex zusammen mit einem elektrisch leitenden, organischen Polymeren aufgetragen werden sollen, ist es notwendig, beide Komponenten in einem gemeinsamen Lösungsmittel oder Lösungsmittelgemisch zu einer Beschichtungslösung aufzulösen.

### Ausführungsbeispiel

Zur Herstellung von [(dmbtacn)Tb(C₂H₅OH)₂] werden 320 mg N,N',N"-Tris-(3,5-dimethyl-2-hydroxybenzyl)-1,4,7-triazacyclononan in 50 ml Ethanol gelöst. Zu dieser Lösung werden 6 ml einer 0.1 molaren TbCl₃-Lösung gegeben. Anschließend werden der Lösung noch 97.2 mg NaOCH₃ hinzugefügt. Die Lösung wird zwei Stunden bei 60°C gerührt, wobei sich ein weißer Niederschlag bildet. Das Produkt wird abgesaugt und mehrmals mit etwas eiskaltem Ethanol gewaschen. Die kristalline Substanz wird im Exsikkator über CaCl₂ getrocknet.

Die photophysikalische Charakterisierung des Pulvers von [(dmbtacn)Tb(C₂H₅OH)₂] ergab folgende Werte:

| Abs₂₅₄[%] | QE₂₅₄[%] | EX bei [nm] | EM bei [nm] | τ [ms]* | LE [1m/W] | Farbpunkt |
|---|---|---|---|---|---|---|
| 93 | 70 | 322 | 496,549,590 625 | 0,79 | 515 | x=0,332 y=0.603 |

| | | | | | | |
|---|---|---|---|---|---|---|
| * monoexponentieller Verlauf | | | | | | |

### Glossar

- Abs₂₅₄: Absorption bei 254 nm
- EM: Maxima im Emissionsspektrum
- EX: Maxima im Excitationsspektrum
- τ: Abklingzeit der Intensität auf 1/e
- LE: Lumenäquivalent
- LMCT: Ligand-Metall-Charge-Transfer
- QE₂₅₄: Quantenausbeute bei Anregung mit 254 nm -Strahlung
- dmbtacn: N,N',N"-Tris-(3,5-dimethyl-2-hydroxybenzyl)-1,4,7-triazacyclononan

## Patentansprüche

1. Organische lichtemittierende Diode mit einem Schichtverbund aus aufeinanderfolgend einer Substratschicht, einer ersten Elektrodenschicht, einer Schicht mit einem p-leitenden Material, einer Schicht mit einer Komplexverbindung des Terbiums mit organischen Liganden, einer Schicht mit einem n-leitendem Material und einer zweiten Elektrode,
**dadurch gekennzeichnet,**
**daß** die Komplexverbindung des Terbiums mit organischen Liganden die Zusammensetzung TbL(C₂H₅OH)₂ mit L = N,N',N" -Tris- (3-R₁-,5-R₂-2-X-benzyl)-1,4,7-triazacyclononan, wobei X= -O-, -COO-, R₁ = CH₃, C₂H₅, C₃H₇, i-C₃H₇, t-C₄H₉, OCH₃, OC₂H₅, OC₃H₇, O^{t}C₄H₉, F, Cl, Br, NO₂ und R₂ = CH₃, C₂H₅, C₃H₇, i-C₃H₇, t-C₄H₉, OCH₃, OC₂H₅, OC₃H₇, O^{t}C₄H₉, F, Cl, Br, NO₂ ist, hat.

## Claims

1. An organic light-emitting diode which comprises a laminated structure comprising, in succession, a substrate layer, a first electrode layer, a layer including a p-conductive material, a layer including a complex compound of terbium with organic ligands, a layer including an n-conductive material and a second electrode, **characterized in that** the complex compound of terbium with organic ligands has the following composition: TbL(C₂H₅OH)₂, wherein L = N,N',N" -Tris- (3-R₁,5-R₂-2-X-benzyl)-1,4,7-triazacyclononane, wherein X = -O-, -COO-, R₁ = CH₃, C₂H₅, C₃H₇, i-C₃H₇, t-C₄H₉, OCH₃, OC₂H₅, OC₃H₇, O^{t}C₄H₉, F, Cl, Br, NO₂ and R₂ = CH₃, C₂H₅, C₃H₇, i-C₃H₇, t-C₄H₉, OCH₃, OC₂H₅, OC₃H₇, O^{t}C₄H₉, F, Cl, Br, NO₂.

## Revendications

1. Diode électroluminescente organique avec une structure en couches composée successivement d'une couche de substrat, d'une première couche d'électrode, d'une couche avec un matériau p-conducteur, d'une couche avec un composé complexé de terbium avec des ligands organiques, d'une couche avec un matériau n-conducteur et d'une deuxième électrode,
**caractérisée en ce que** le composé complexé de terbium avec des ligands organiques présente la composition TbL(C₂H₅OH)₂ avec L = N,N',N"-Tris-(3-R₁-,5-R₂-2-X-benzyl)-1,4,7-triazacyclononane, X étant = -O-, COO-, R₁ = CH₃, C₂H₅, C₃H₇, i-C₃H₇, t-C₄H₉, OCH₃, OC₂H₅, OC₃H₇, O^{t}C₄H₉, F, Cl, Br, NO₂ et R₂ = CH₃, C₂H₅, C₃H₇, i-C₃H₇, t-C₄H₉, OCH₃, OC₂H₅, OC₃H₇, O^{t}C₄H₉, F, Cl, Br, NO₂.
